# EUROPEAN PATENT SPECIFICATION

(11) **EP 2 896 966 B1**
(45) Date of publication and mention of the grant of the patent: **23.06.2021**
(21) Application number: 14200644.4
(22) Date of filing: 30.12.2014
(51) Int. Cl.: G01P 1/02, G01P 3/488, G01D 11/24, G01D 11/30

(54) **Positioning frame structure**
Positionierungs-Rahmenstruktur
Structure de cadre de positionnement

(30) Priority: 31.12.2013 CN 201310752418
(43) Date of publication of application: 22.07.2015
(73) Proprietor: Sensata Technologies (Changzhou) Co., Ltd, Changzhou Jiangsu 213031 (CN)
(72) Inventor: Wu, Tianshun, 201202 Pudong Xinqu (CN); Huang, Chengwei, 200434 Hongkou Zone (CN); Xu, Xiaochi, 200051 Changning Zone (CN)
(74) Representative: Hopley, Joanne Selina

(56) References cited:
- FR-A1- 2 902 872
- US-A- 5 321 355
- US-A- 5 414 355
- US-A- 5 500 589
- US-A1- 2005 007 098
- US-B1- 6 291 990
- None

## Description

### Technical Field

The present invention is related to a positioning frame structure, and more particularly, to a positioning frame structure for accurate centering and positioning between an integrated chip and a positioning magnet.

### Background of the Art

It is well known that the speed of a target wheel can be detected using a non-contact encoder of a magnetic sensor, such as Hall sensor, anisotropy reluctance sensor and large reluctance sensor. Such sensor can be known as speed sensor, such as Two-Wire Hall Effect Directional Output Speed Sensor (TOSS), Integrated Directional Clutch Input Speed Sensor (CISS) and Non-directional Input Speed Sensor (TISS). The function, performance and design for these sensors are well known in the art. The speed sensors are capable of sensing rotational speed of a target utilized in automotive transmission application.

These speed sensors are used in both input and output encoder application during the target spinning. Typically, they have small package Integrated Chips (ICs) on the top side of magnets, with a magnet located in a carrier. During the operation process, the centering and positioning of the IC on the magnet are required to be controlled. In the prior art, the IC is generally assembled on the carrier, so that the centering between the IC and the magnet is controlled by means of the inner diameter of a hole in the carrier, and the positioning of the IC is controlled through ribs on the carrier. In this case, the magnet should has a size smaller than that of the IC in order to ensure that the centering can be performed, while the IC should be secured by an adhesive, which creates a problem of production cost.

Since the size of the magnet is smaller than that of the IC, the above solution is not suitable for a smaller IC. The operation of centering and positioning is complex, because the IC needs to be secured by an adhesive. Thus, there is a need for a positioning structure, which can be adapted to position an IC having a size smaller than a positioning magnet, and simplify the construction and operation and reduce the cost.

US 5500589 discloses a magnetic sensor comprising a carrier with a cavity shaped to receive a bias magnet. A sensor arrangement is mounted on the end of the carrier with pegs on the carrier engaging with holes in the circuit board of the sensor arrangement. A desired calibration is achieved by advancing the magnet into the cavity, crushing a rib inside the cavity as it advances, until the desired calibration is arrived at. The magnet is held in that place by the rib and then by potting the device.

US 5414355 discloses a magnetic sensor having a carrier in which a moulded magnet is disposed. A housing receives the carrier and a substrate bearing a magnetically sensitive component. Protrusions at the end of carrier engage the substrate.

US6291990 also discloses a magnetic sensor having a magnet mounted in a molded synthetic resin holder. A circuit board bearing a Hall sensor is mounted on the end of the holder on projections at the end of the holder.

US5321355 discloses a magnetic sensor comprising a hollow and open ended cylindrical magnet having at each end a plate pole piece across the end having with a central hole. A flux return coupling member passes through the hole at one end through the space inside the magnet and its other end approaches the hole at other end. A Hall sensor is mounted covering the hole at that other end, optionally in a slot in the diffusion plate. The plate pole pieces spread the magnetic field can even field across the sensor, which filed changes in magnitude depending on whether a tooth on a wheel to be sensed is near or not. The whole device may be encapsulated for protection.

FR2902872 discloses a sensor having a Hall effect element (but no bias magnet) for sensing the magnetic field from an external rotating magnetic ring. The sensor is mounted on the edge of a circuit board. In one example the Hall sensor is mounted within a hole in circuit board to allow the sensor to be coplanar with the circuit board or retracted within it, allowing it to be brought close to magnetic ring to increase sensitivity.

US20050007098 discloses a sensor for an idler wheel having a magnetic ring that rotates with the wheel. The sensor IC has a mount comprising a cover, which engages a static part of the wheel mount, and a resin moulded member which extends through the cover towards the ring. At the end of the resin mounted member a holder member holds the sensor IC, without stress close to the magnetic ring.

### Description of the Invention

Therefore, an object of the present invention is to provide a positioning frame structure for accurate centering and positioning between an integrated chip and a positioning magnet. The positioning frame structure can be adapted to position an IC having a size smaller than a positioning magnet, and eliminate the need of adhesive in prior art, so as to reduce the cost.

The above object is achieved through a positioning frame structure for the centering and positioning of an integrated circuit (IC), comprising a magnetic sensor, in which the positioning frame structure comprises:
an IC carrier having a first chamber and a second chamber;
an IC holder configured to receive the IC; and
an IC positioning magnet,
wherein the IC positioning magnet is disposed in the first chamber, and the IC holder is fixed and removably disposed in the second chamber so that the IC holder is disposed above the IC positioning magnet disposed within the first chamber so as to center and position the IC relative to the IC positioning magnet,
   wherein a size of the IC positioning magnet is larger than a size of the IC,
   wherein a size of the second chamber is larger than a size of the first chamber,
   wherein the IC holder comprises a receiving portion, the IC being held in the receiving portion, the receiving portion being sized and shaped to correspond to the size and shape of the IC so that the IC can be fixedly disposed in the receiving portion,
   wherein the first chamber comprises an open top, and
   wherein the second chamber comprises:
      a bottom comprising a shoulder formed between the top of the first chamber and the circumference of the second chamber, the IC holder abutting against the shoulder;
      a circumference comprising a plurality of walls extending from an outer circumference of the shoulder; and
      an open top.

In one embodiment, the outer periphery of the IC holder is sized to correspond to the size of the second chamber of the IC carrier, so that the IC holder can be fixedly disposed within the second chamber.

By means of the above solution, the positioning frame structure of the present invention can be used to control and thus ensure the centering and positioning of the IC and the positioning magnet on the carrier. The present invention can be used for the operation of a smaller IC, i.e. the IC can be used in a small package. In addition, a large air gap can be obtained so as to facilitate the subsequent operation of the IC.

Furthermore, without the operation using adhesive, the technical solution of the present invention saves the cost of operation as compared with the IC positioning manner in prior art.

### Drawings description

The present invention will now be described in detail by means of embodiments of a positioning frame structure with reference to the accompanied figures, wherein:
Figure 1 is a longitudinal cross-sectional perspective view of a positioning frame structure according to the present invention;
Figure 2 is a traversal cross-sectional view of a positioning frame structure according to the present invention.

### Detail Description of the Embodiments of the Present Invention

Referring to the figures, a positioning frame structure of the present invention will now be in detail described. The positioning frame structure of the present invention is used for the centering and positioning of an Integrated Chip (IC), especially the centering and positioning of an IC in small package on a large IC positioning magnet.

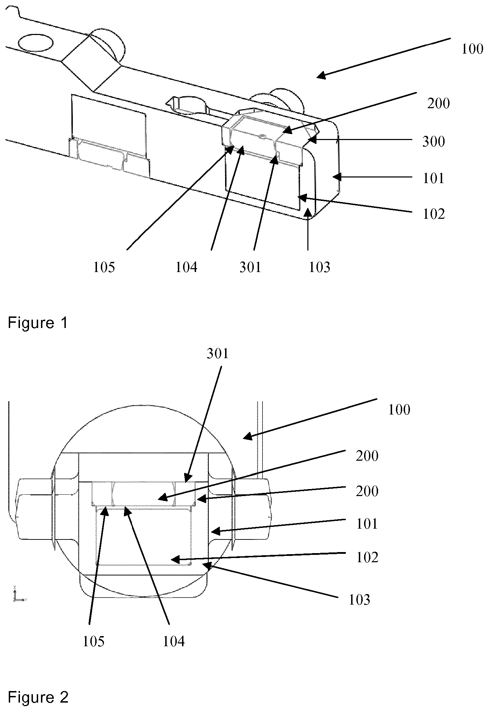

Referring now to figures 1 and 2, which are a longitudinal cross-sectional perspective view and a traversal cross-sectional view of a positioning frame structure 100 according to the present invention, respectively. In the figures 1 and 2, the positioning frame structure 100 generally comprises an IC carrier 101 and an IC positioning magnet 102. The IC carrier 101 has a first chamber 103 defined therein. In the illustrated embodiment, the cross section of the first chamber 103 is square in shape. However, it will be appreciated that the first chamber 103 can be any other suitable shape.

The IC positioning magnet 102 is disposed within the first chamber 103 of the IC carrier 101. In embodiments, the IC positioning magnet 102 is sized to correspond to the size of the first chamber 103 of the IC carrier 101, so that the IC positioning magnet 102 can be fixedly disposed in the first chamber 103, and thus the centering and positioning between the IC positioning magnet 102 and the IC carrier 101 can be controlled and ensured.

The positioning frame structure 100 according to the present invention is provided with an IC holder 300, which is disposed over the IC positioning magnet 102. In practice, an IC 200 is held in the IC holder 300, so that the centering and positioning of the IC 200 relative to the IC positioning magnet 102 can be obtained by means of the IC holder 300.

The size of the IC positioning magnet 102 is larger than the size of the IC 200, so as to meet some special requirements in the field of chip package. Further, due to the IC holder 300, the size of the IC 200 can be very small, so as to overcome the drawback in prior art that the centering and positioning of the IC cannot be obtained if the IC is in small package.

The IC holder 300 is provided with a receiving portion 301 and the IC 200 can be held in the receiving portion 301. The receiving portion 301 is sized and shaped to correspond to the size and shape of the IC 200, so that the IC 200 can be fixedly and removably disposed in the receiving portion 301.

The IC carrier 101 is further provided with a second chamber 104. The second chamber 104 is located above the first chamber 103.

The IC holder 300 is disposed within the second chamber 104 of the IC carrier 101.

The size of the second chamber 104 is larger than the size of the first chamber 103. A shoulder 105 is formed between the first chamber 103 and the second chamber 104. The IC holder 300 abuts against the shoulder 105.

In a preferred embodiment, the outer periphery of the IC holder 300 is sized to correspond to the size of the second chamber 104 of the IC carrier 101, so that the IC holder 300 can be fixedly and removably disposed within the second chamber 104. The centering and positioning between the IC 200 and the IC positioning magnet 102 is ensured by means of the structural relationship between the IC carrier 101, the IC positioning magnet 102 and the IC holder 300.

The IC holder 300 and the second chamber 104 can be suitable shapes, for example, in the illustrated embodiment, the second chamber 104 has a cross section of symmetric hexagon, and the IC holder 300 has a cross section of corresponding symmetric hexagon, so as to generally conform to that of the second chamber 104. In the illustrated embodiment, a plurality of sides (which can be part or all of the sides) of the IC holder 300 abut against the corresponding inner sides of the second chamber 104, so that the IC holder 300 can be secured in place relative to the second chamber 104.

It is apparent for the skilled in the art that the IC holder 300 and the second chamber 104 can be any other suitable shapes, as long as the centering and positioning between the IC 200 and the IC positioning magnet 102 can be ensured.

In addition, in order to further enhance the IC 200 being secured in the receiving portion 301 of the IC holder, an additional securing means can be provided, for example, the IC 200 can be secured in the receiving portion 301 by means of a snap fit.

By means of the above solution, the positioning frame structure of the present invention can be used to control and thus ensure the centering and positioning of the IC and the positioning magnet on the carrier. Due to the present of the IC holder, the positioning magnet can be made to be larger than the IC. In this case, the present invention can be used for the operation of a smaller IC, i.e. the IC can be used in a small package. In addition, a large air gap can be obtained so as to facilitate the subsequent operation of the IC.

Furthermore, without the operation using adhesive, the technical solution of the present invention saves the cost of operation as compared with the IC positioning manner in prior art.

While the present invention has been described in detail by way of the above preferred embodiments, it is obvious to the skilled in the art that the present invention does not limit to the above embodiments. Changes can be made, as long as they are contained within the scope of the invention as defined by the claims.

## Claims

1. A positioning frame structure, 100, for the centering and positioning of an integrated circuit (IC), 200, comprising a magnetic sensor, in which the positioning frame structure comprises:
an IC carrier, 101, having a first chamber, 103, and a second chamber, 104;
an IC holder, 300, configured to receive the IC; and
an IC positioning magnet, 102,
wherein the IC positioning magnet is disposed in the first chamber, and the IC holder is fixedly and removably disposed in the second chamber so that the IC holder is disposed above the IC positioning magnet disposed within the first chamber so as to center and position the IC relative to the IC positioning magnet,
wherein a size of the IC positioning magnet is larger than a size of the IC,
wherein a size of the second chamber is larger than a size of the first chamber,
wherein the IC holder comprises a receiving portion, the IC being held in the receiving portion, the receiving portion being sized and shaped to correspond to the size and shape of the IC so that the IC can be fixedly disposed in the receiving portion,
wherein the first chamber comprises an open top, and wherein the second chamber comprises:
a bottom comprising a shoulder formed between the top of the first chamber and the circumference of the second chamber, the IC holder abutting against the shoulder;
a circumference comprising a plurality of walls extending from an outer circumference of the shoulder; and
an open top.

2. The positioning frame structure according to claim 1, wherein first chamber includes a lower end and an upper end, the second chamber includes a lower end and an upper end, and the lower end of the second chamber is proximate to the upper end of the first chamber.

3. The positioning frame structure according to claim 1, wherein the IC positioning magnet is sized to correspond to the size of the first chamber of the IC carrier, so that the IC positioning magnet can be fixedly disposed in the first chamber.

4. The positioning frame structure according to claim 1, wherein the outer periphery of the IC holder is sized to correspond to the size of the second chamber of the IC carrier.

5. The positioning frame structure according to claim 1, wherein the first chamber has a cross section which is square or rectangular in shape and/or the second chamber has a cross section which is square or rectangular in shape.

## Patentansprüche

1. Positionierungs-Rahmenstruktur, 100, zum Zentrieren und Positionieren einer integrierten Schaltung (IS), 200, die einen Magnetsensor umfasst, wobei die Positionierungs-Rahmenstruktur umfasst:
Einen IS-Träger, 101, mit einer ersten Kammer, 103, und einer zweiten Kammer, 104;
einen IS-Halter, 300, der ausgelegt ist, die IS aufzunehmen; und
einen IS-Positioniermagnet, 102,
wobei der IS-Positioniermagnet in der ersten Kammer angeordnet ist, und der IS-Halter ortsfest und entfernbar in der zweiten Kammer angeordnet ist, sodass der IS-Halter über dem IS-Positioniermagnet angeordnet ist, der innerhalb der ersten Kammer angeordnet ist, um die IS relativ zum IS-Positioniermagnet zu zentrieren und positionieren,
wobei eine Größe des IS-Positioniermagnets größer als eine Größe der IS ist,
wobei eine Größe der zweiten Kammer größer als eine Größe der ersten Kammer ist,
wobei der IS-Halter einen Aufnahmeabschnitt umfasst, die IS im Aufnahmeabschnitt gehalten wird, wobei der Aufnahmeabschnitt bemessen und geformt ist, um der Größe und Form der IS zu entsprechen, sodass die IS ortsfest im Aufnahmeabschnitt angeordnet werden kann,
wobei die erste Kammer eine offene Oberseite umfasst und wobei die zweite Kammer umfasst:
eine Basis, die eine zwischen der Oberseite der ersten Kammer und dem Umfang der zweiten Kammer geformte Schulter umfasst, wobei der IS-Halter gegen die Schulter anstößt;
einen Umfang, der eine Vielzahl von Wänden umfasst, die sich aus einem Außenumfang der Schulter erstrecken; und
eine offene Oberseite.

2. Positionierungs-Rahmenstruktur nach Anspruch 1, wobei die erste Kammer ein unteres Ende und ein oberes Ende einschließt, die zweite Kammer ein unteres Ende und ein oberes Ende einschließt und das untere Ende der zweiten Kammer nahe dem oberen Ende der ersten Kammer ist.

3. Positionierungs-Rahmenstruktur nach Anspruch 1, wobei der IS-Positioniermagnet bemessen ist, der Größe der ersten Kammer des IS-Trägers zu entsprechen, sodass sich der IS-Positioniermagnet ortsfest in der ersten Kammer anordnen lässt.

4. Positionierungs-Rahmenstruktur nach Anspruch 1, wobei der Außenumfang des IS-Halters bemessen ist, der Größe der zweiten Kammer des IS-Trägers zu entsprechen.

5. Positionierungs-Rahmenstruktur nach Anspruch 1, wobei die erste Kammer einen Querschnitt aufweist, der quadratischer oder rechteckiger Form ist, und/oder die zweite Kammer einen Querschnitt aufweist, der quadratischer oder rechteckiger Form ist.

## Revendications

1. Une structure de cadre de positionnement, 100, destinée au centrage et au positionnement d'un circuit intégré (IC), 200, comprenant un capteur magnétique, dans lequel la structure de cadre de positionnement comprend :
un support pour IC, 101, possédant une première chambre, 103, et une deuxième chambre, 104,
un porte-IC, 300, configuré de façon à recevoir l'IC, et
un aimant de positionnement d'IC, 102,
où l'aimant de positionnement d'IC est disposé dans la première chambre, et le porte-IC est disposé de manière fixe et amovible dans la deuxième chambre de sorte que le porte-IC soit disposé au-dessus de l'aimant de positionnement d'IC disposé à l'intérieur de la première chambre de façon à centrer et positionner l'IC par rapport à l'aimant de positionnement d'IC,
où une taille de l'aimant de positionnement d'IC est supérieure à une taille de l'IC,
où une taille de la deuxième chambre est supérieure à une taille de la première chambre,
où le porte-IC comprend une partie de réception, l'IC étant maintenu dans la partie de réception, la partie de réception étant dimensionnée et façonnée de façon à correspondre à la taille et la forme de l'IC de sorte que l'IC puisse être disposé de manière fixe dans la partie de réception,
où la première chambre comprend une partie supérieure ouverte, et où la deuxième chambre comprend :
une partie inférieure comprenant un épaulement formé entre la partie supérieure de la première chambre et la circonférence de la deuxième chambre, le porte-IC venant en butée contre l'épaulement,
une circonférence comprenant une pluralité de parois s'étendant à partir d'une circonférence extérieure de l'épaulement, et
une partie supérieure ouverte.

2. La structure de cadre de positionnement selon la Revendication 1, où la première chambre comprend une extrémité inférieure et une extrémité supérieure, la deuxième chambre comprend une extrémité inférieure et une extrémité supérieure, et l'extrémité inférieure de la deuxième chambre est proche de l'extrémité supérieure de la première chambre.

3. La structure de cadre de positionnement selon la Revendication 1, où l'aimant de positionnement d'IC est dimensionné de façon à correspondre à la taille de la première chambre du support pour IC, de sorte que l'aimant de positionnement d'IC puisse être disposé de manière fixe dans la première chambre.

4. La structure de cadre de positionnement selon la Revendication 1, où la périphérie extérieure du porte-IC est dimensionnée de façon à correspondre à la taille de la deuxième chambre du support pour IC.

5. La structure de cadre de positionnement selon la Revendication 1, où la première chambre possède une section transversale qui est de forme carrée ou rectangulaire et/ou la deuxième chambre possède une section transversale qui est de forme carrée ou rectangulaire.
